# EUROPÄISCHE PATENTSCHRIFT

(11) **EP 3 928 399 B1**
(45) Veröffentlichungstag und Bekanntmachung des Hinweises auf die Patenterteilung: **03.05.2023**
(21) Anmeldenummer: 19716815.6
(22) Anmeldetag: 28.03.2019
(51) Int. Cl.: H02H 1/00, G01R 31/08, H02M 1/32, H02H 1/04, H02H 7/10

(54) **VERFAHREN ZUM ERKENNEN EINES LICHTBOGENS**
METHOD FOR DETECTING AN ARC
PROCÉDÉ DE DÉTECTION D'UN ARC ÉLECTRIQUE

(43) Veröffentlichungstag der Anmeldung: 29.12.2021
(73) Patentinhaber: Siemens Energy Global GmbH & Co. KG, 81739 München (DE)
(72) Erfinder: ARMSCHAT, Christoph, 91058 Erlangen (DE); SCHREMMER, Frank, 90768 Fürth (DE); JÄNICKE, Lutz-Rüdiger, 15831 Mahlow (DE)
(86) Internationale Anmeldenummer: PCT/EP2019/057825
(87) Internationale Veröffentlichungsnummer: WO 2020/192921

(56) Entgegenhaltungen:
- EP-A1- 0 575 932
- EP-A1- 2 549 634
- EP-A2- 1 710 592
- DE-A1-102009 038 209

## Beschreibung

Bei Leistungshalbleiterbauelementen können im Fehlerfall Lichtbögen auftreten, welche erhebliche Schäden verursachen. Durch einen brennenden Lichtbogen bzw. ein daraus entstehendes Feuer in einem das Leistungshalbleiterbauelement umgebenden Gehäuse kann nicht nur das Leistungshalbleiterbauelement zerstört werden, sondern es kann auch das Gehäuse zerstört und daraufhin die Umgebung des Gehäuses in Mitleidenschaft gezogen werden. Schließlich kann die gesamte leistungselektronische Anlage, in der sich das Leistungshalbleiterbauelement befindet, verunreinigt, beschädigt oder sogar zerstört werden.

Ein Beispiel hierfür ist ein modularer MultilevelStromrichter, der eine Reihe von Modulen aufweist. In jedem Modul befinden sich ein oder mehrere Leistungshalbleiterbauelemente. Die Module sind als zweipolige Module ausgeführt, haben also zwei Anschlüsse. Zwischen den beiden Anschlüssen ist ein Überbrückungsschalter zum Überbrücken des Moduls bei Auftreten eines Fehlers in dem Modul angeordnet.

Sobald ein Fehler in dem Modul erkannt wird, wird der Überbrückungsschalter geschlossen, um das Modul zu überbrücken (kurzzuschließen). Dann fließt der Strom über den Überbrückungsschalter und nicht länger durch das fehlerhafte Modul. Falls der Überbrückungsschalter jedoch aus irgendeinem Grund nicht schließt, dann fließt der Strom weiterhin über das Leistungshalbleiterbauelement des Moduls, und an diesem Leistungshalbleiterbauelement kann ein Lichtbogen entstehen bzw. weiterbrennen. Ein solcher Lichtbogen zerstört binnen kürzester Zeit das Leistungshalbleiterbauelement sowie die in der Umgebung befindlichen Bauelemente. Nach einigen Sekunden wird der Lichtbogen in der Regel auch ein Kapselungsgehäuse zerstören, welches das Leistungshalbleiterbauelement umgibt. Sobald das Kapselungsgehäuse zerstört ist, treten auch Schäden außerhalb des Kapselungsgehäuses auf. In der Folge muss der gesamte Multilevelstromrichter abgeschaltet und repariert werden.

Ein Verfahren zur Erkennung eines fehlerhaften Leistungshalbleiterbauelements ist in EP 2 549 634 A1 offenbart. Andere Dokumente, wie EP 0 575 932 A1, EP 1 710 592 A2 oder DE 10 2009 038209 A1, zeigen Vorrichtungen, die zur Erkennung von Störlichtbögen benutzt werden.

Der Erfindung liegt die Aufgabe zugrunde, ein Verfahren und eine leistungselektronische Anlage anzugeben, mit denen das Auftreten eines Lichtbogens bei einem Leistungshalbleiterbauelement erkannt werden kann.

Diese Aufgabe wird erfindungsgemäß gelöst durch ein Verfahren und durch eine leistungselektronische Anlage nach den unabhängigen Patentansprüchen. Vorteilhafte Ausführungsformen des Verfahrens und der Anlage sind in den abhängigen Patentansprüchen angegeben.

Offenbart wird ein Verfahren zum Erkennen eines Lichtbogens bei einem Leistungshalbleiterbauelement (insbesondere bei einem Leistungshalbleiterbauelement einer Hochspannungsanlage oder eines Stromrichters), bei dem eine dem Leistungshalbleiterbauelement zugeordnete Bauelement-Steuereinheit über einen ersten optischen Kommunikationspfad Nachrichten zu einer übergeordneten Steuereinheit überträgt, wobei bei dem Verfahren
- von dem Lichtbogen ausgesendetes Licht mittels eines zweiten optischen Kommunikationspfads zu dem ersten optischen Kommunikationspfad übertragen wird,
- dieses Licht in den ersten optischen Kommunikationspfad (optisch) eingekoppelt wird,
- durch dieses eingekoppelte Licht die von der Bauelement-Steuereinheit über den ersten optischen Kommunikationspfad zu der übergeordneten Steuereinheit stattfindende Nachrichtenübertragung gestört wird, und
- von der übergeordneten Steuereinheit aufgrund dieser gestörten Nachrichtenübertragung der Lichtbogen erkannt wird. Von der übergeordneten Steuereinheit wird also aufgrund der gestörten Nachrichtenübertragung erkannt, dass ein Lichtbogen brennt. Das Leistungshalbleiterbauelement kann insbesondere in einem Kapselungsgehäuse angeordnet sein. Dabei ist besonders vorteilhaft, dass das von dem Lichtbogen ausgesendete Licht in den ersten optischen Kommunikationspfad eingekoppelt wird. Es wird also der erste optische Kommunikationspfad zusätzlich dazu genutzt, dass von dem Lichtbogen ausgesendete Licht zu der übergeordneten Steuereinheit zu übertragen. Dadurch wird kein weiterer optischer Kommunikationspfad zu der übergeordneten Steuereinheit benötigt. Bei dem oftmals erheblichen Abstand zwischen dem Leistungshalbleiterbauelement und der übergeordneten Steuereinheit können dadurch erhebliche Kosten für einen weiteren optischen Kommunikationspfad vermieden werden.

Das Verfahren kann auch so ablaufen, dass von der übergeordneten Steuereinheit erst dann (aufgrund der gestörten Nachrichtenübertragung) der (brennende) Lichtbogen erkannt wird, wenn die von der Bauelement-Steuereinheit über den ersten optischen Kommunikationspfad zu der übergeordneten Steuereinheit stattfindende Nachrichtenübertragung mindestens 2 Sekunden lang gestört ist, insbesondere mindestens 4 Sekunden lang gestört ist. Dadurch wird vorteilhafterweise vermieden, dass ein kurzzeitig brennender Lichtbogen, der bald wieder verlischt, als Lichtbogen erkannt wird, und daraufhin den Lichtbogen betreffende Aktionen ausgelöst werden. Wenn der Lichtbogen nach kurzer Zeit verlischt, insbesondere nach einigen hundert Millisekunden, sind derartige spezielle Aktionen nicht notwendig.

Das Verfahren kann auch so ablaufen, dass das Leistungshalbleiterbauelement und ein Eingang des zweiten optischen Kommunikationspfads in einem Kapselungsgehäuse angeordnet sind, und mittels des zweiten optischen Kommunikationspfads das von dem Lichtbogen ausgesendete Licht aus dem Kapselungsgehäuse herausgeleitet wird. Ein derartiges Kapselungsgehäuse schützt die Umgebung des Leistungshalbleiterbauelements bei einem Fehler des Leistungshalbleiterbauelements. Insbesondere ist ein solches Kapselungsgehäuse in der Lage, einem an dem Leistungshalbleiterbauelement brennenden Lichtbogen einige Sekunden lang zu widerstehen. Ein dauerhaft brennender Lichtbogen würde jedoch das Kapselungsgehäuse zerstören. Daher muss ein dauerhaft brennender Lichtbogen erkannt werden, bevor er das Kapselungsgehäuse durchgebrannt hat.

Das Verfahren kann auch so ablaufen, dass das von dem Lichtbogen ausgesendete Licht gesammelt und in den zweiten optischen Kommunikationspfad eingeleitet wird (insbesondere in einen Eingang des zweiten optischen Kommunikationspfads eingeleitet wird) mittels einer lichtsammelnden Optik. Dadurch wird mehr Licht mittels des zweiten optischen Kommunikationspfads zu dem ersten optischen Kommunikationspfad übertragen, so dass die Erkennung des Lichtbogens mit einer großen Zuverlässigkeit erfolgt.

Das Verfahren kann auch so ablaufen, dass die lichtsammelnde Optik an dem zweiten optischen Kommunikationspfad angeordnet ist, insbesondere an dem Eingang des zweiten optischen Kommunikationspfads angeordnet ist. Dadurch bilden die lichtsammelnde Optik und der zweite optische Kommunikationspfad eine Einheit; diese Einheit kann vergleichsweise einfach in der Nähe des Leistungshalbleiterbauelements montiert werden.

Das Verfahren kann auch so ablaufen, dass der erste optische Kommunikationspfad und/oder der zweite optische Kommunikationspfad jeweils als ein Lichtwellenleiter ausgestaltet ist. Lichtwellenleiter sind am Markt in ausreichender Menge und Qualität verfügbar.

Das Verfahren kann auch so ablaufen, dass das Leistungshalbleiterbauelement ein Leistungshalbleiterbauelement eines Moduls eines modularen Multilevelstromrichters ist. Dann ist die Bauelement-Steuereinheit insbesondere eine modulinterne Steuereinheit und die übergeordnete Steuereinheit ist insbesondere eine modulexterne Steuereinheit. Die übergeordnete Steuereinheit ist dann einer Vielzahl von Modulen zugeordnet; die übergeordnete Steuereinheit steuert die Vielzahl von Modulen. Die übergeordnete Steuereinheit wird im Wesentlichen auf Erdpotential betrieben; die Bauelement-Steuereinheit wird auf dem elektrischen Potential des jeweiligen Moduls betrieben. Das Verfahren ist also insbesondere bei einem modularen Multilevelstromrichter vorteilhaft einsetzbar. Ein derartiger modularer Multilevelstromrichter weist nämlich in der Regel eine große Anzahl von Modulen auf. Wenn von jedem Modul des modularen Multilevelstromrichters ein zusätzlicher optischer Kommunikationspfad zu der übergeordneten Steuereinheit verlegt werden müsste (um einen eventuell in dem Modul auftretenden Lichtbogen zu erkennen), dann wäre eine große Anzahl zusätzlicher optischer Kommunikationspfade notwendig. Dies würde erhebliche Kosten verursachen. Bei dem beschriebenen Verfahren können diese Kosten vermieden werden, weil der (sowieso zur Nachrichtenübertragung zwischen der Bauelementsteuereinheit und der übergeordneten Steuereinheit vorhandene) erste optische Kommunikationspfad zusätzlich dazu genutzt wird, einen Lichtbogen zu erkennen.

Das Verfahren kann auch so ablaufen, dass das Modul zwei Anschlüsse aufweist, zwischen denen ein Überbrückungsschalter zum Überbrücken des Moduls bei Auftreten eines Fehlers in dem Modul angeordnet ist. Mittels eines derartigen Überbrückungsschalters kann im Fehlerfall das fehlerbehaftete Modul überbrückt (kurzgeschlossen) werden. Nach dem Überbrücken des Moduls mittels des Überbrückungsschalters verlischt ein ggf. bei dem Leistungshalbleiterbauelement des Moduls brennender Lichtbogen. Wenn der Überbrückungsschalter innerhalb einer kurzen Zeitspanne (oftmals im Bereich von wenigen Millisekunden bis zu wenigen hundert Millisekunden) schließt, dann brennt der Lichtbogen nur eine sehr kurze Zeit und erlischt danach von selbst. Ein derart kurzzeitig brennender Lichtbogen braucht nicht unbedingt zusätzlich erkannt zu werden, weil keine zusätzlichen Aktionen notwendig sind. Wenn jedoch aus irgendeinem Grund der Überbrückungsschalter im Fehlerfall versagt und nicht schließt, dann würde der Lichtbogen bei dem Leistungshalbleiterbauelement des Moduls weiterbrennen und große Schäden verursachen. Also ist insbesondere bei einem Versagen des Überbrückungsschalters das Verfahren zum Erkennen des Lichtbogens mit Vorteil anwendbar.

Offenbart wird weiterhin eine leistungselektronische Anlage, mit einem Leistungshalbleiterbauelement, mit einer dem Leistungshalbleiterbauelement zugeordnete Bauelement-Steuereinheit (zum Ansteuern des Leistungshalbleiterbauelements), wobei die Bauelement-Steuereinheit (zum Zwecke der Nachrichtenübertragung) mittels eines ersten optischen Kommunikationspfads mit einer übergeordneten Steuereinheit verbunden ist, und mit einem zweiten optischen Kommunikationspfad, der eine Übertragung von Licht von dem Leistungshalbleiterbauelement zu dem ersten optischen Kommunikationspfad ermöglicht, wobei - der zweite optische Kommunikationspfad so ausgestaltet ist, dass er von einem (im Fehlerfall) bei dem Leistungshalbleiterbauelement brennenden Lichtbogen ausgesendetes Licht zu dem ersten optischen Kommunikationspfad überträgt und in den ersten optischen Kommunikationspfad (optisch) einkoppelt (einspeist). Die leistungselektronische Anlage kann insbesondere eine Hochspannungsanlage oder ein Stromrichter sein.

Der zweite optische Kommunikationspfad überträgt also von dem Lichtbogen, der im Fehlerfall bei dem Leistungshalbleiterbauelement brennt, ausgesendetes Licht zu dem ersten optischen Kommunikationspfad und koppelt dieses Licht in den ersten optischen Kommunikationspfad (optisch) ein. Dabei ist es ausreichend, wenn der zweite optische Kommunikationspfad einen (insbesondere kleinen) Teil des gesamten von dem Lichtbogen ausgesendeten Lichts zu dem ersten optischen Kommunikationspfad überträgt. Der zweite optische Kommunikationspfad ist an den ersten optischen Kommunikationspfad optisch angekoppelt. Der zweite optische Kommunikationspfad verläuft insbesondere von dem Leistungshalbleiterbauelement zu dem ersten optischen Kommunikationspfad. Im Falle eines brennenden Lichtbogens stört also die Lichtübertragung mittels des zweiten optischen Kommunikationspfads die von der Bauelement-Steuereinheit zu der übergeordneten Steuereinheit über den ersten optischen Kommunikationspfad stattfindende Nachrichtenübertragung. Diese Störung der Nachrichtenübertragung ermöglicht es der übergeordneten Steuereinheit, den brennenden Lichtbogen zu erkennen.

Die leistungselektronische Anlage kann so ausgestaltet sein, dass das Leistungshalbleiterbauelement und ein Eingang des zweiten optischen Kommunikationspfads in einem Kapselungsgehäuse angeordnet sind und der zweite optische Kommunikationspfad aus dem Kapselungsgehäuse herausführt.

Die lichtsammelnde Optik kann auch so ausgestaltet sein, dass sie von dem Lichtbogen ausgesendetes Licht sammelt und in den zweiten optischen Kommunikationspfad einleitet (insbesondere in einen Eingang des zweiten optischen Kommunikationspfads einleitet).

Die leistungselektronische Anlage kann auch so ausgestaltet sein, dass die lichtsammelnde Optik an dem zweiten optischen Kommunikationspfad angeordnet ist, insbesondere an dem Eingang des zweiten optischen Kommunikationspfads angeordnet ist.

Die leistungselektronische Anlage kann so ausgestaltet sein, dass der erste optische Kommunikationspfad und/oder der zweite optische Kommunikationspfad jeweils als ein Lichtwellenleiter ausgestaltet ist.

Die leistungselektronische Anlage kann auch so ausgestaltet sein, dass das Leistungshalbleiterbauelement ein Leistungshalbleiterbauelement eines Moduls eines modularen Multilevelstromrichters ist.

Die leistungselektronische Anlage kann so ausgestaltet sein, dass das Modul zwei Anschlüsse aufweist, zwischen denen ein Überbrückungsschalter zum Überbrücken des Moduls bei Auftreten eines Fehlers in dem Modul (modulinterner Fehler) angeordnet ist.

Das beschriebene Verfahren und die beschriebene leistungselektronische Anlage weisen gleiche beziehungsweise gleichartige Vorteile auf.

Im Folgenden wird die Erfindung anhand von Ausführungsbeispielen näher erläutert. Gleiche Bezugszeichen verweisen dabei auf gleiche oder gleichwirkende Elemente. Dazu ist in
- Figur 1: ein Ausführungsbeispiel einer leistungselektronischen Anlage in Form eines Multilevelstromrichters, in
- Figur 2: ein Ausführungsbeispiel eines Moduls der leistungselektronischen Anlage, in
- Figur 3: ein Ausführungsbeispiel eines weiteren Moduls der leistungselektronischen Anlage, in
- Figur 4: ein Ausschnitt aus der leistungselektronischen Anlage mit einem beispielhaften Verfahrensablauf, und in
- Figur 5: ein weiterer Ausschnitt aus der leistungselektronischen Anlage mit einem beispielhaften Verfahrensablauf
dargestellt.

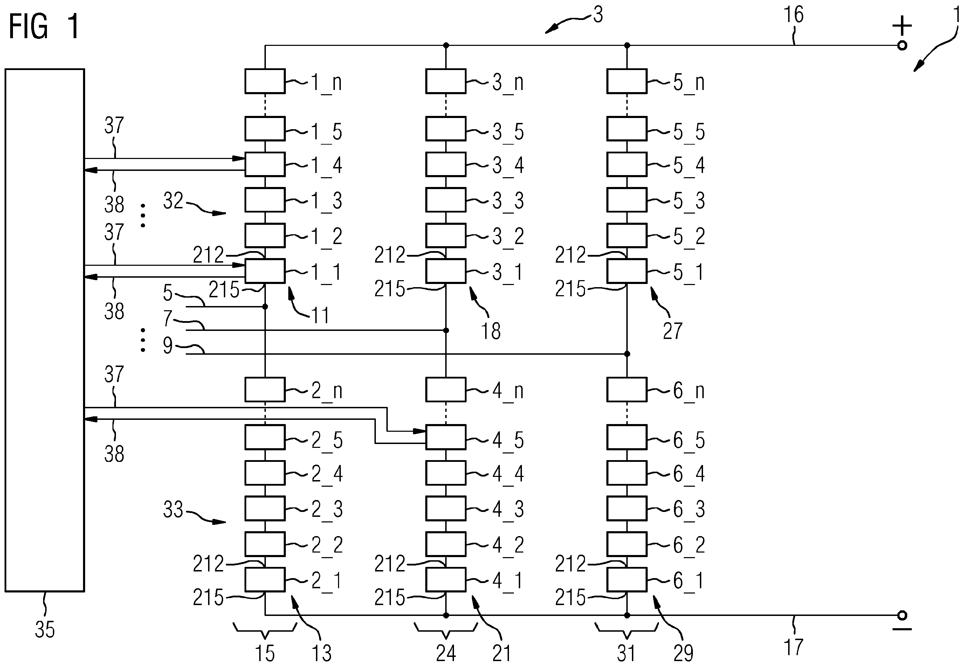

In Figur 1 ist ein Multilevelstromrichter 1 als Ausführungsbeispiel für eine leistungselektronischen Anlage 1 dargestellt. Dieser Multilevelstromrichter 1 weist einen ersten Wechselspannungsanschluss 5, einen zweiten Wechselspannungsanschluss 7 und einen dritten Wechselspannungsanschluss 9 auf. Der erste Wechselspannungsanschluss 5 ist elektrisch mit einem ersten Phasenmodulzweig 11 und einem zweiten Phasenmodulzweig 13 verbunden. Der erste Phasenmodulzweig 11 und der zweite Phasenmodulzweig 13 bilden ein erstes Phasenmodul 15 des Stromrichters 3. Das dem ersten Wechselspannungsanschluss 5 abgewandte Ende des ersten Phasenmodulzweigs 11 ist mit einem ersten Gleichspannungsanschluss 16 elektrisch verbunden; das dem ersten Wechselspannungsanschluss 5 abgewandte Ende des zweiten Phasenmodulzweigs 13 ist mit einem zweiten Gleichspannungsanschluss 17 elektrisch verbunden. Der erste Gleichspannungsanschluss 16 ist ein positiver Gleichspannungsanschluss; der zweite Gleichspannungsanschluss 17 ist ein negativer Gleichspannungsanschluss.

Der zweite Wechselspannungsanschluss 7 ist mit einem Ende eines dritten Phasenmodulzweigs 18 und mit einem Ende eines vierten Phasenmodulzweigs 21 elektrisch verbunden. Der dritte Phasenmodulzweig 18 und der vierte Phasenmodulzweig 21 bilden ein zweites Phasenmodul 24. Der dritte Wechselspannungsanschluss 9 ist mit einem Ende eines fünften Phasenmodulzweigs 27 und mit einem Ende eines sechsten Phasenmodulzweigs 29 elektrisch verbunden. Der fünfte Phasenmodulzweig 27 und der sechste Phasenmodulzweig 29 bilden ein drittes Phasenmodul 31.

Das dem zweiten Wechselspannungsanschluss 7 abgewandte Ende des dritten Phasenmodulzweigs 18 und das dem dritten Wechselspannungsanschluss 9 abgewandte Ende des fünften Phasenmodulzweigs 27 sind mit dem ersten Gleichspannungsanschluss 16 elektrisch verbunden. Das dem zweiten Wechselspannungsanschluss 7 abgewandte Ende des vierten Phasenmodulzweigs 21 und das dem dritten Wechselspannungsanschluss 9 abgewandte Ende des sechsten Phasenmodulzweigs 29 sind mit dem zweiten Gleichspannungsanschluss 17 elektrisch verbunden. Der erste Phasenmodulzweig 11, der dritte Phasenmodulzweig 18 und der fünfte Phasenmodulzweig 27 bilden ein positivseitiges Stromrichterteil 32; der zweite Phasenmodulzweig 13, der vierte Phasenmodulzweig 21 und der sechste Phasenmodulzweig 29 bilden ein negativseitiges Stromrichterteil 33.

Jeder Phasenmodulzweig weist eine Mehrzahl von Modulen (1_1, 1_2, 1_3, 1_4 ... 1_n; 2_1 ... 2_n; usw.) auf, welche (mittels ihrer Modulanschlüsse) elektrisch in Reihe geschaltet sind. Solche Module werden auch als Submodule bezeichnet. Im Ausführungsbeispiel der Figur 1 weist jeder Phasenmodulzweig n Module auf. Die Anzahl der mittels ihrer Modulanschlüsse elektrisch in Reihe geschalteten Module kann sehr verschieden sein, mindestens sind drei Module in Reihe geschaltet, es können aber auch beispielsweise 50, 100 oder mehr Module elektrisch in Reihe geschaltet sein. Im Ausführungsbeispiel ist n = 36: der erste Phasenmodulzweig 11 weist also 36 Module 1_1, 1_2, 1_3, ... 1_36 auf. Die anderen Phasenmodulzweige 13, 18, 21, 27 und 29 sind gleichartig aufgebaut.

Im linken Bereich der Figur 1 ist schematisch eine übergeordnete Steuereinheit/Steuereinrichtung 35 (zentrale Steuereinheit/Steuereinrichtung 35) für die Module 1_1 bis 6_n dargestellt. Von dieser übergeordneten Steuereinheit 35 werden optische Nachrichten bzw. optische Signale über jeweils einen optischen Kommunikationspfad 37 (eine optische Kommunikationsverbindung 37) zu den einzelnen Modulen übertragen. Die einzelnen Module übertragen optische Nachrichten bzw. optische Signale über jeweils einen optischen Kommunikationspfad 38 (eine optische Kommunikationsverbindung 38) zu der übergeordneten Steuereinheit 35. Die optischen Kommunikationspfade 37 und 38 können zum Beispiel jeweils als ein Lichtwellenleiter ausgebildet sein. Die optischen Kommunikationspfade 37 und 38 sind beispielhaft nur für die Module 1_1, 1_4 und 4_5 dargestellt; zu den anderen Modulen sind gleichartige optischen Kommunikationspfade 37 und 38 installiert. Beispielsweise sendet die übergeordneten Steuereinheit 35 an die einzelnen Module jeweils eine Nachricht mit einem Sollwert für den Schaltzustand der elektronischen Schaltelemente der Module. Die einzelnen Module antworten mit einer Antwortnachricht, mit der sie den Schaltzustand ihrer elektronischen Schaltelemente an die übergeordneten Steuereinheit 35 übertragen.

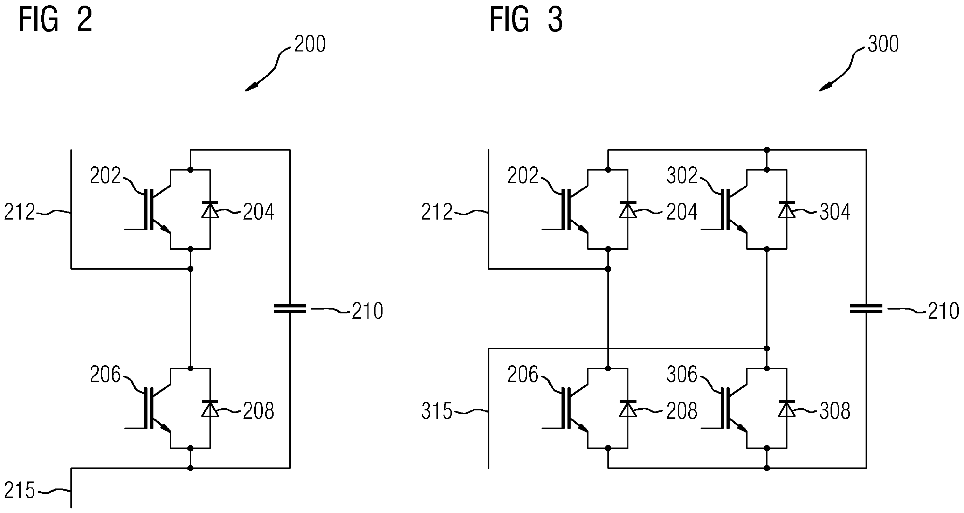

In Figur 2 ist ein Ausführungsbeispiel eines Moduls 200 des modularen Multilevelstromrichters 1 dargestellt. Bei dem Modul kann es sich beispielsweise um eines der in Figur 1 dargestellten Module 1_1 ... 6_n handeln. Es können auch mehrere oder alle Module des modularen Multilevelstromrichters 1 so ausgestaltet sein wie das dargestellte Modul 200. Das Modul 200 ist als ein Halbbrücken-Modul 200 ausgestaltet. Das Modul 200 weist ein erstes (abschaltbares) elektronisches Schaltelement 202 (erstes abschaltbares Halbleiterventil 202) mit einer ersten antiparallel geschalteten Diode 204 auf. Weiterhin weist das Modul 200 ein zweites (abschaltbares) elektronisches Schaltelement 206 (zweites abschaltbares Halbleiterventil 206) mit einer zweiten antiparallel geschalteten Diode 208 sowie einen elektrischen Energiespeicher 210 in Form eines Kondensators 210 auf. Das erste elektronische Schaltelement 202 und das zweite elektronische Schaltelement 206 sind jeweils als ein IGBT (insulated-gate bipolar transistor) ausgestaltet. Das erste elektronische Schaltelement 202 ist elektrisch in Reihe geschaltet mit dem zweiten elektronischen Schaltelement 206. Am Verbindungspunkt zwischen den beiden elektronischen Schaltelementen 202 und 206 ist ein erster Modulanschluss 212 angeordnet. An dem Anschluss des zweiten elektronischen Schaltelements 206, welcher dem Verbindungspunkt gegenüberliegt, ist ein zweiter Modulanschluss 215 angeordnet. Der zweite Modulanschluss 215 ist weiterhin mit einem ersten Anschluss des Energiespeichers 210 elektrisch verbunden; ein zweiter Anschluss des Energiespeichers 210 ist elektrisch verbunden mit dem Anschluss des ersten elektronischen Schaltelements 202, der dem Verbindungspunkt gegenüberliegt.

Der Energiespeicher 210 ist also elektrisch parallel geschaltet zu der Reihenschaltung aus dem ersten elektronischen Schaltelement 202 und dem zweiten elektronischen Schaltelement 206. Durch entsprechende Ansteuerung des ersten elektronischen Schaltelements 202 und des zweiten elektronischen Schaltelements 206 mittels der übergeordneten Steuereinheit 35 des Stromrichters kann erreicht werden, dass zwischen dem ersten Modulanschluss 212 und dem zweiten Modulanschluss 215 entweder die Spannung des Energiespeichers 210 ausgegeben wird oder keine Spannung ausgegeben wird (d.h. eine Nullspannung ausgegeben wird). Durch Zusammenwirken der Module der einzelnen Phasenmodulzweige kann so die jeweils gewünschte Ausgangsspannung des Stromrichters erzeugt werden. Der Energiespeicher kann ein Kondensator sein (oder eine Zusammenschaltung aus mehreren Kondensatoren); die Spannung des Energiespeichers ist dann die Kondensatorspannung (oder die Gesamtspannung der Zusammenschaltung). Das erste elektronische Schaltelement 202 und das zweite elektronische Schaltelement 206 sind jeweils ein Leistungshalbleiterbauelement, an dem im Fehlerfall ein Lichtbogen entstehen kann.

In Figur 3 ist ein weiteres Ausführungsbeispiel eines Moduls 300 des modularen Multilevelstromrichters 1 dargestellt. Bei dem Modul 300 kann es sich beispielsweise um eines der in Figur 1 dargestellten Module 1_1 ... 6_n handeln. Es können auch mehrere oder alle Module des modularen Multilevelstromrichters 1 so ausgestaltet sein wie das dargestellte Modul 300.

Neben den bereits aus Figur 2 bekannten ersten elektronischen Schaltelement 202, zweiten elektronischen Schaltelement 206, erster Freilaufdiode 204, zweiter Freilaufdiode 208 und Energiespeicher 210 weist das in Figur 3 dargestellte Modul 300 ein drittes elektronisches Schaltelement 302 mit einer antiparallel geschalteten dritten Freilaufiode 304 sowie ein viertes elektronisches Schaltelement 306 mit einer vierten antiparallel geschalteten Freilaufdiode 308 auf. Das dritte elektronische Schaltelement 302 und das vierte elektronische Schaltelement 306 sind jeweils als ein IGBT ausgestaltet. Im Unterschied zur Schaltung der Figur 2 ist der zweite Modulanschluss 315 nicht mit dem zweiten elektronischen Schaltelement 206 elektrisch verbunden, sondern mit einem Mittelpunkt (Verbindungspunkt) einer elektrischen Reihenschaltung aus dem dritten elektronischen Schaltelement 302 und dem vierten elektronischen Schaltelement 306.

Das Modul der Figur 3 ist ein sogenanntes Vollbrücken-Modul 300. Dieses Vollbrücken-Modul 300 zeichnet sich dadurch aus, dass bei entsprechender Ansteuerung der vier elektronischen Schaltelemente zwischen dem ersten Modulanschluss 212 und dem zweiten Modulanschluss 315 wahlweise entweder die positive Spannung des Energiespeichers 210, die negative Spannung des Energiespeichers 210 oder eine Spannung des Wertes Null (Nullspannung) ausgegeben werden kann. Somit kann also mittels des Vollbrückenmoduls 300 die Polarität der Ausgangsspannung umgekehrt werden. Der Multilevelstromrichter 1 kann entweder nur Halbbrücken-Module 200, nur Vollbrücken-Module 300 oder auch Halbbrücken-Module 200 und Vollbrücken-Module 300 aufweisen.

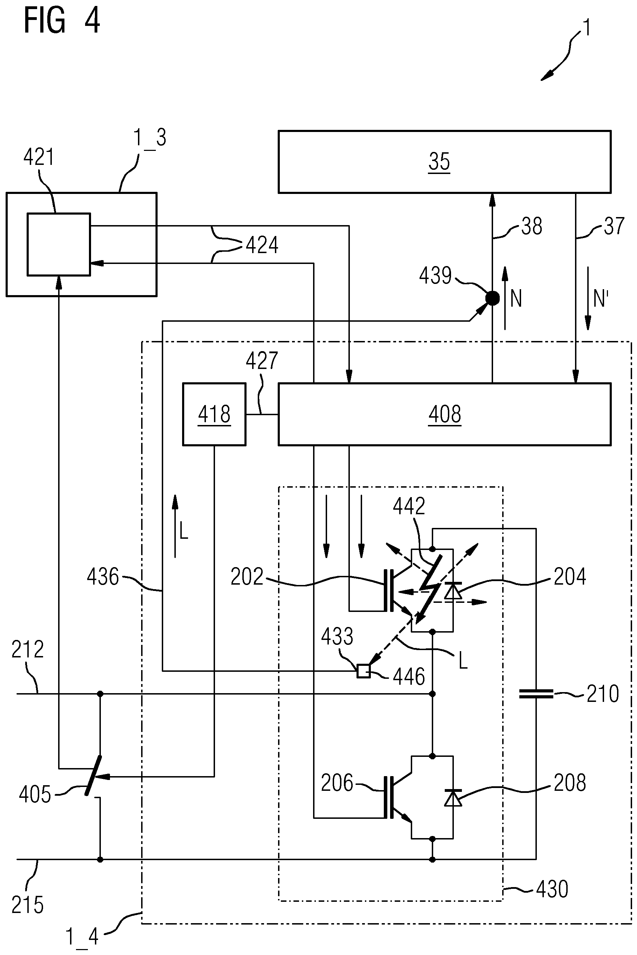

In Figur 4 ist ein Ausschnitt aus der leistungselektronischen Anlage 1 dargestellt. Dabei ist beispielhaft das Modul 1_4, sowie das Nachbarmodul 1_3 (das heißt, dass zu dem Modul 1_4 in der elektrischen Reihenschaltung benachbarte Modul 1_3) dargestellt sowie die übergeordnete Steuereinheit 35.

Das Modul 1_4 ist im Ausführungsbeispiel als ein Halbbrückenmodul ausgestaltet und weist die bereits aus Figur 2 bekannten Elemente 202, 204, 206, 208, 210, 212 und 215 auf. Zwischen dem ersten elektrischen Modulanschluss 212 und dem zweiten elektrischen Modulanschluss 215 ist ein Überbrückungsschalter 405 angeordnet. Mittels dieses Überbrückungsschalters 405 kann das Modul 1_4 bei Auftreten eines Fehlers überbrückt (kurzgeschlossen) werden.

Das erste elektronische Schaltelement 202 ist im Ausführungsbeispiel ein Leistungshalbleiterbauelement 202. Dieses Leistungshalbleiterbauelement 202 (und auch das zweite elektronische Schaltelement 206, welches ebenfalls ein Leistungshalbleiterbauelement 206 darstellt) werden mittels der Bauelement-Steuereinheit 408 angesteuert. Die Bauelement-Steuereinheit 408 ist Bestandteil des Moduls 1_4 und wird auf dem elektrischen Potential des Moduls 1_4 betrieben. Die Leitungen zwischen der Bauelement-Steuereinheit 408 und den Leistungshalbleiterbauelementen 202 und 206 sind als elektrische (galvanische) Leitungen ausgeführt. Die Bauelement-Steuereinheit 408 kommuniziert über den ersten optischen Kommunikationspfad 38 mit der übergeordneten Steuereinheit 35. Dazu sendet die Bauelement-Steuereinheit 408 Nachrichten N über den ersten optischen Kommunikationspfad 38 zu der übergeordneten Steuereinheit 35. Die übergeordnete Steuereinheit 35 sendet über einen dritten optischen Kommunikationspfad 37 Nachrichten N' an die Bauelement-Steuereinheit 408. Der erste optische Kommunikationspfad 38 und/oder der dritte optische Kommunikationspfad 37 sind im Ausführungsbeispiel als Lichtwellenleiter ausgestaltet. Dadurch wird eine elektrische Potentialtrennung zwischen der Bauelement-Steuereinheit 408 und der übergeordneten Steuereinheit 35 erreicht. Die übergeordnete Steuereinheit 35 ist im Wesentlichen auf Erdpotential angeordnet, wohingegen die Bauelement-Steuereinheit 408 auf dem elektrischen Potential des Moduls 1_4 angeordnet ist. Dadurch können sich erhebliche Potentialdifferenzen zwischen der Bauelement-Steuereinheit 408 und der übergeordneten Steuereinheit 35 ergeben.

Der Überbrückungsschalter 405 wird von einer Überbrückungsschalter-Steuereinheit 418 angesteuert. Bei Auftreten eines Fehlers in dem Modul 1_4 sendet die Überbrückungsschalter-Steuereinheit 418 ein entsprechendes Signal/Nachricht an den Überbrückungsschalter 405, woraufhin der Überbrückungsschalter 405 schließt. Das korrekte Schließen des Überbrückungsschalters 405 wird von einer Prüfschaltung 421 überwacht, welche in dem Nachbarmodul 1_3 angeordnet ist. Das Nachbarmodul 1_3 (genauer gesagt, die Prüfschaltung 421 des Nachbarmoduls 1_3) ist mit der Bauelement-Steuereinheit 408 des Moduls 1_4 mittels optischer Kommunikationspfade 424 verbunden. Innerhalb des Moduls 1_4 ist die Bauelement-Steuereinheit 408 mit der Überbrückungsschalter-Steuereinheit 418 mittels einer elektrischen (galvanischen) Kommunikationsverbindung 427 elektrisch verbunden.

Das erste Leistungshalbleiterbauelement 202, das zweite Leistungshalbleiterbauelement 206 sowie die beiden Dioden 204 und 208 sind in einem Kapselungsgehäuse 430 angeordnet. In dem Kapselungsgehäuse 430 ist weiterhin ein Eingang 433 eines zweiten optischen Kommunikationspfades 436 angeordnet. Der zweite optische Kommunikationspfad 436 erstreckt sich zu dem ersten optischen Kommunikationspfad 38. An einem Einkopplungspunkt 439 ist der zweite optische Kommunikationspfad 436 an den ersten optischen Kommunikationspfad 38 angekoppelt. Daher kann der zweite optische Kommunikationspfad 436 Licht in den ersten optischen Kommunikationspfad 38 einkoppeln.

Der Einkopplungspunkt 439, an dem das Licht von dem zweiten optischen Kommunikationspfad 436 in den ersten optischen Kommunikationspfad 38 eingekoppelt wird, kann unterschiedlich realisiert sein. Beispielsweise kann der Einkopplungspunkt 439 eine optische Weiche aufweisen oder die beiden Kommunikationspfade 436 und 38 können ineinander übergehen.

Im Normalbetrieb kommuniziert die Bauelement-Steuereinheit 408 mittels der über den ersten optischen Kommunikationspfad 38 gesendeten Nachrichten N und der über den dritten optischen Kommunikationspfad 37 gesendeten Nachrichten N' mit der übergeordneten Steuereinheit 35. Die Nachrichten N und N' sind beispielsweise als sogenannte Nachrichtentelegramme ausgestaltet, das heißt, diese Nachrichten weisen eine bestimmte Struktur auf, welche sowohl von der Bauelement-Steuereinheit 408 als auch von der übergeordneten Steuereinheit 35 verstanden wird. Die Nachrichten N und N` werden mittels Licht über die optischen Kommunikationspfade 38 und 37 übertragen.

Wenn im Modul 1_4 ein Fehler auftritt, dann kann dieser Fehler dazu führen, dass beispielsweise das erste Leistungshalbleiterbauelement 202 nicht mehr korrekt abgeschaltet werden kann und daraufhin (aufgrund des großen durch das Leistungshalbleiterbauelement 202 fließenden Stroms und einer daraus resultierenden thermischen Überlastung und Zerstörung des Leistungshalbleiterbauelements 202) ein Lichtbogen 442 an dem Leistungshalbleiterbauelement 202 auftritt. Dieser Lichtbogen 442 würde im Ausführungsbeispiel den Kollektor und den Emitter des Leistungshalbleiterbauelements 202 elektrisch miteinander verbinden. Solange dieser Lichtbogen 442 im Inneren des Kapselungsgehäuses 430 brennt, hält sich der Schaden in Grenzen. Wenn jedoch der Lichtbogen 442 langzeitig brennt, dann zerstört er das Kapselungsgehäuse 430 und der Lichtbogen (bzw. das im Kapselungsgehäuse 430 brennende Feuer) greift zunächst auf das Modul 1_4 und später auf außerhalb des Moduls 1_4 angeordnete Teile des Stromrichters über. Dann können großflächige Defekte und/oder Verschmutzungen des Multilevel-Stromrichters auftreten, was kostspielige Reparaturarbeiten nach sich ziehen kann.

Sobald der Lichtbogen 442 brennt, sendet der Lichtbogen Licht aus. Bei diesem von dem Lichtbogen 442 ausgesendeten Licht kann es sich beispielsweise um UV-Licht handeln oder um das breitere Licht-Spektrum eines Feuers. Ein Teil des von dem Lichtbogen 442 ausgesendeten Lichts gelangt zu einer lichtsammelnden Optik 446, welche an dem Eingang 433 des zweiten optischen Kommunikationspfads 436 angeordnet ist. Insbesondere kann die lichtsammelnde Optik 446 an dem zweiten optischen Kommunikationspfad 436 bzw. an dem Eingang 433 des zweiten optischen Kommunikationspfades 436 befestigt sein. Die Optik 446 sammelt das Licht und leitet das Licht L in den Eingang 433 des zweiten optischen Kommunikationspfads 436 ein.

Die lichtsammelnde Optik 446 kann auf verschiedene Art und Weise ausgestaltet sein: beispielsweise als eine optische Linse (Sammellinse) oder als eine Scheibe, die am Rand mit einem Reflektor versehen ist und die das Licht in den Eingang 433 des zweiten optischen Kommunikationspfades 436 einspeist.

Der zweite optische Kommunikationspfad 436 überträgt das von dem Lichtbogen 442 stammende Licht L zu dem ersten optischen Kommunikationspfad 38 und koppelt dieses Licht L an dem Einkoppelungspunkt 439 in den ersten optischen Kommunikationspfad 38 ein. Mittels des zweiten optischen Kommunikationspfads 436 wird also ein kleiner Teil des von dem Lichtbogen/Feuer 442 stammenden Lichts L aus dem (in der Regel undurchsichtigen) Kapselungsgehäuse 430 herausgeleitet und zu dem ersten optischen Kommunikationspfad 38 übertragen.

Daraufhin wird durch dieses von dem Lichtbogen 442 stammende Licht L die Nachrichtenübertragung N zwischen der Bauelement-Steuereinheit 408 und der übergeordneten Steuereinheit 35 gestört. Solange der Lichtbogen 442 brennt, wird mittels des zweiten optischen Kommunikationspfads 436 ein dauerhaftes Lichtsignal L (Dauerlicht L, Störlicht L) in den ersten optischen Kommunikationspfad 38 eingekoppelt/eingespeist. Dieses Licht L wird mittels des ersten optischen Kommunikationspfads 38 zu der übergeordneten Steuereinheit 35 geleitet. Dieses dauerhafte Lichtsignal L stört die über den ersten optischen Kommunikationspfad 38 stattfindende Nachrichtenübertragung. Bei dieser Nachrichtenübertragung wird nämlich kein dauerhaftes Lichtsignal verwendet (dauerlichtfreie Nachrichtenübertragung). Sobald die übergeordnete Steuereinheit 35 das dauerhafte Lichtsignal L detektiert, erkennt die übergeordnete Steuereinheit 35, dass ein Lichtbogen brennt. Anhand des Auftretens des dauerhaften Lichtsignals L wird also der Lichtbogen erkannt. Die übergeordnete Steuereinheit 35 erkennt aufgrund der durch das Licht L gestörten Nachrichtenübertragung, dass in dem Modul 1_4 ein Lichtbogen brennt. Daraufhin gibt die übergeordnete Steuereinheit 35 ein entsprechendes Fehlersignal aus. Insbesondere gibt die übergeordnete Steuereinheit 35 erst nach einer Verzögerungszeit das Fehlersignal aus. Dieses Fehlersignal kann (insbesondere "UND"-verknüpft mit einem oder mehreren anderen Signalen) die Abschaltung des Stromrichters auslösen. Das Fehlersignal kann insbesondere die Information "Modul-Überbrückungsschalter ist nicht geschlossen" beinhalten, da ein dauerhaft brennender Lichtbogen nur bei nicht geschlossenem Überbrückungsschalter 405 auftreten kann.

Optional kann das Verfahren auch so ablaufen, dass die übergeordnete Steuereinheit 35 erst dann den brennenden Lichtbogen erkennt und also auch erst dann das Fehlersignal ausgibt, wenn die von der Bauelement-Steuereinheit 408 zu der übergeordneten Steuereinheit 35 stattfindende Nachrichtenübertragung N mindestens 2 Sekunden lang gestört ist, insbesondere mindestens 4 Sekunden lang gestört ist. Wenn nämlich die Störung der Nachrichtenübertragung innerhalb der ersten 2 Sekunden bzw. innerhalb der ersten 4 Sekunden wieder beendet ist, dann bedeutet dies, dass der Lichtbogen 442 innerhalb der 2 bzw. 4 Sekunden wieder erloschen ist. In diesem Fall braucht die übergeordnete Steuereinheit 35 kein Fehlersignal auszugeben, weil der Lichtbogen 442 innerhalb dieser kurzen Zeitspanne (2 bzw. 4 Sekunden) innerhalb des Kapselungsgehäuses 430 verbleiben würde uns somit keine größeren Schäden zu erwarten sind. Insbesondere verlischt der Lichtbogen 442 dann, wenn der Überbrückungsschalter 405 geschlossen wird.

Das beschriebene Verfahren kann insbesondere mit Vorteil angewendet werden, wenn das Nachbarmodul 1_3 des Moduls 1_4 bereits früher ausgefallen und daher nicht mehr funktionsfähig ist. Dann kann mittels der Prüfschaltung 421 nicht mehr erkannt werden, ob der Überbrückungsschalter 405 (im Fehlerfall) ordnungsgemäß schließt. Mittels des beschriebenen Verfahrens und der beschriebenen Anlage kann jedoch auch in einem derartigen Fall mittels des zweiten optischen Kommunikationspfads 436 zuverlässig erkannt werden, ob bei einem Leistungshalbleiterbauelement des Moduls ein Lichtbogen brennt. Wenn ein Lichtbogen erkannt wird, dann kann die übergeordnete Steuereinheit 35 ein entsprechendes Fehlersignal ausgeben, woraufhin geeignete Maßnahmen ergriffen werden können. Beispielsweise kann in einem derartigen Fall das betroffene Phasenmodul des Stromrichters oder der gesamte Stromrichter (im Allgemeinen also die gesamte leistungselektronische Anlage) abgeschaltet werden, um eine Ausbreitung des Schadens aus dem Modul 1_4 heraus zu verhindern.

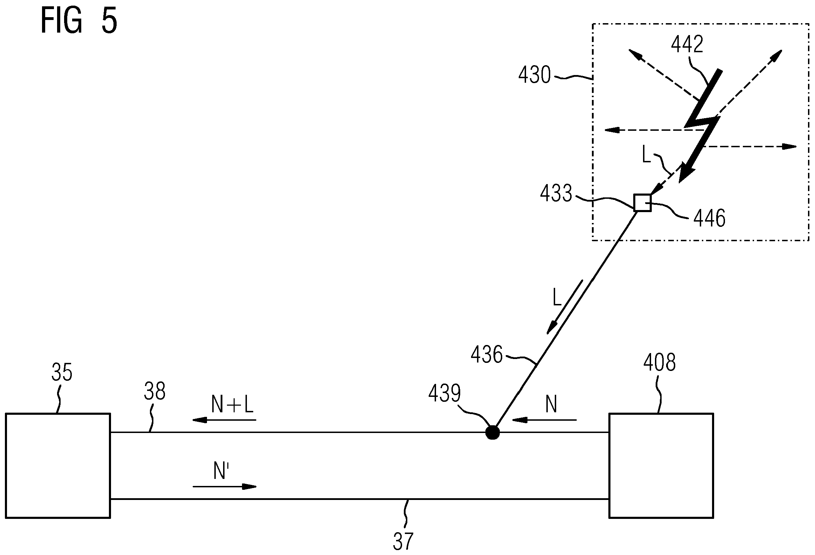

In Figur 5 sind noch einmal die Schritte des Verfahrens zum Erkennen des Lichtbogens in einer anderen Darstellungsform gezeigt. Es ist deutlich zu erkennen, wie das von dem Lichtbogen 242 ausgesendete Licht (genauer gesagt, ein Teil L des von dem Lichtbogen 242 ausgesendete Lichts) über den zweiten optischen Kommunikationspfad 436 zu dem ersten optischen Kommunikationspfad 38 übertragen und in diesen ersten optischen Kommunikationspfad 38 eingekoppelt/eingeleitet wird. Das Licht L überlagert die optischen Nachrichten N, die von der Bauelement-Steuereinheit 408 über den ersten optischen Kommunikationspfad 38 zu der übergeordneten Steuereinheit 35 übertragen werden. Dadurch wird die Nachrichtenübertragung von der Bauelement-Steuereinheit 408 zu der übergeordneten Steuereinheit 35 gestört. Aufgrund dieser Störung erkennt die übergeordnete Steuereinheit 35, dass der Lichtbogen 442 brennt.

Dabei ist insbesondere der Einkopplungspunkt 439 näher an der Bauelement-Steuereinheit 408 angeordnet als an der übergeordneten Steuereinheit 35. Der Einkopplungspunkt 439 ist also benachbart zu dem Modul 1_4 angeordnet. Dadurch braucht der zweite optische Kommunikationspfad 436 nur eine geringe Länge aufweisen im Vergleich zur Länge des ersten optischen Kommunikationspfads 38. Beispielsweise kann der erste optische Kommunikationspfad 38 mindestens 10 Mal länger sein als der zweite optische Kommunikationspfad 436. Insbesondere kann der erste optische Kommunikationspfad 38 zwischen 10 und 1000 Mal länger sein als der zweite optische Kommunikationspfad 436.

Im Ausführungsbeispiel kommunizieren die Bauelement-Steuereinheit 408 und die übergeordnete Steuereinheit 35 mittels zweier optischer Kommunikationspfade 38 und 37 miteinander. In einem anderen Ausführungsbeispiel kann die Bauelement-Steuereinheit 408 jedoch auch mittels eines einzigen (bidirektionalen) optischen Kommunikationspfades mit der übergeordneten Steuereinheit 35 kommunizieren. Diese Kommunikation/Nachrichtenübertragung wird dann (wie oben beschrieben) durch die Einkopplung des von dem Lichtbogen 442 stammenden Lichts L in diesen bidirektionalen optischen Kommunikationspfad gestört.

Es wurde ein Verfahren und eine leistungselektronische Anlage beschrieben, mit denen sicher und zuverlässig das Auftreten eines Lichtbogens erkannt werden kann.

## Patentansprüche

1. Verfahren zum Erkennen eines Lichtbogens (442) bei einem Leistungshalbleiterbauelement (202), bei dem eine dem Leistungshalbleiterbauelement (202) zugeordnete Bauelement-Steuereinheit (408) über einen ersten optischen Kommunikationspfad (38) Nachrichten (N) zu einer übergeordneten Steuereinheit (35) überträgt, wobei bei dem Verfahren
- von dem Lichtbogen (442) ausgesendetes Licht (L) mittels eines zweiten optischen Kommunikationspfads (436) zu dem ersten optischen Kommunikationspfad (38) übertragen wird,
- dieses Licht (L) in den ersten optischen Kommunikationspfad (38) eingekoppelt wird,
- durch dieses eingekoppelte Licht (L) die von der Bauelement-Steuereinheit (408) über den ersten optischen Kommunikationspfad (38) zu der übergeordneten Steuereinheit (35) stattfindende Nachrichtenübertragung gestört wird, und
- von der übergeordneten Steuereinheit (35) aufgrund dieser gestörten Nachrichtenübertragung der Lichtbogen (442) erkannt wird.

2. Verfahren nach Anspruch 1,
**dadurch gekennzeichnet, dass**
- von der übergeordneten Steuereinheit (35) erst dann der Lichtbogen (442) erkannt wird, wenn die von der Bauelement-Steuereinheit (408) über den ersten optischen Kommunikationspfad (38) zu der übergeordneten Steuereinheit (35) stattfindende Nachrichtenübertragung mindestens 2 Sekunden lang, insbesondere mindestens 4 Sekunden lang, gestört ist.

3. Verfahren nach Anspruch 1 oder 2,
**dadurch gekennzeichnet, dass**
- das Leistungshalbleiterbauelement (202) und ein Eingang (433) des zweiten optischen Kommunikationspfads (436) in einem Kapselungsgehäuse (430) angeordnet sind, und mittels des zweiten optischen Kommunikationspfads (436) das von dem Lichtbogen (442) ausgesendete Licht (L) aus dem Kapselungsgehäuse (430) herausgeleitet wird.

4. Verfahren nach einem der vorhergehenden Ansprüche,
**dadurch gekennzeichnet, dass**
- das von dem Lichtbogen (442) ausgesendete Licht gesammelt und in den zweiten optischen Kommunikationspfad (436) eingeleitet wird mittels einer lichtsammelnden Optik (446).

5. Verfahren nach Anspruch 4,
**dadurch gekennzeichnet, dass**
- die lichtsammelnde Optik (446) an dem zweiten optischen Kommunikationspfad (436) angeordnet ist, insbesondere an dem Eingang (433) des zweiten optischen Kommunikationspfads (436) angeordnet ist.

6. Verfahren nach einem der vorhergehenden Ansprüche,
**dadurch gekennzeichnet, dass**
- der erste optische Kommunikationspfad (38) und/oder der zweite optische Kommunikationspfad (436) jeweils als ein Lichtwellenleiter ausgestaltet ist.

7. Verfahren nach einem der vorhergehenden Ansprüche,
**dadurch gekennzeichnet, dass**
- das Leistungshalbleiterbauelement ein Leistungshalbleiterbauelement (202) eines Moduls (1_4) eines modularen Multilevelstromrichters (1) ist.

8. Verfahren nach Anspruch 7,
**dadurch gekennzeichnet, dass**
- das Modul (1_4) zwei Anschlüsse (212, 215) aufweist, zwischen denen ein Überbrückungsschalter (405) zum Überbrücken des Moduls bei Auftreten eines Fehlers in dem Modul angeordnet ist.

9. Leistungselektronische Anlage (1) mit einem Leistungshalbleiterbauelement (202), mit einer dem Leistungshalbleiterbauelement (202) zugeordnete Bauelement-Steuereinheit (408), wobei die Bauelement-Steuereinheit (408) mittels eines ersten optischen Kommunikationspfads (38) mit einer übergeordneten Steuereinheit (35) verbunden ist, und mit einem zweiten optischen Kommunikationspfad (436), der eine Übertragung von Licht von dem Leistungshalbleiterbauelement (202) zu dem ersten optischen Kommunikationspfad (38) ermöglicht, wobei
- der zweite optische Kommunikationspfad (436) so ausgestaltet ist, dass er von einem bei dem Leistungshalbleiterbauelement (202) brennenden Lichtbogen (442) ausgesendetes Licht (L) zu dem ersten optischen Kommunikationspfad (38) überträgt und in den ersten optischen Kommunikationspfad (38) einkoppelt.

10. Leistungselektronische Anlage nach Anspruch 9,
**dadurch gekennzeichnet, dass**
- das Leistungshalbleiterbauelement (202) und ein Eingang (433) des zweiten optischen Kommunikationspfads (436) in einem Kapselungsgehäuse (430) angeordnet sind und der zweite optische Kommunikationspfad (436) aus dem Kapselungsgehäuse (430) herausführt.

11. Leistungselektronische Anlage nach Anspruch 9 oder 10,
**gekennzeichnet durch**
- eine lichtsammelnde Optik (446), die so ausgestaltet ist, dass sie von dem Lichtbogen ausgesendetes Licht sammelt und in den zweiten optischen Kommunikationspfad (436) einleitet.

12. Leistungselektronische Anlage nach Anspruch 11,
**dadurch gekennzeichnet, dass**
- die lichtsammelnde Optik (446) an dem zweiten optischen Kommunikationspfad (436) angeordnet ist, insbesondere an dem Eingang (433) des zweiten optischen Kommunikationspfads (436) angeordnet ist.

13. Leistungselektronische Anlage nach einem der Ansprüche 9 bis 12,
**dadurch gekennzeichnet, dass**
- der erste optische Kommunikationspfad (38) und/oder der zweite optische Kommunikationspfad (436) jeweils als ein Lichtwellenleiter ausgestaltet ist.

14. Leistungselektronische Anlage nach einem der Ansprüche 9 bis 13,
**dadurch gekennzeichnet, dass**
- das Leistungshalbleiterbauelement ein Leistungshalbleiterbauelement (202) eines Moduls (1_4) eines modularen Multilevelstromrichters (1) ist.

15. Leistungselektronische Anlage nach einem der Ansprüche 9 bis 14,
**dadurch gekennzeichnet, dass**
- das Modul (1_4) zwei Anschlüsse (212, 215) aufweist, zwischen denen ein Überbrückungsschalter (405) zum Überbrücken des Moduls bei Auftreten eines Fehlers in dem Modul angeordnet ist.

## Claims

1. Method for detecting an arc (442) in a power semiconductor component (202) in which a component control unit (408) assigned to the power semiconductor component (202) transfers messages (N) to a superordinate control unit (35) via a first optical communication path (38), wherein in the method
- light (L) emitted by the arc (442) is transferred to the first optical communication path (38) by means of a second optical communication path (436),
- said light (L) is coupled into the first optical communication path (38),
- the message transfer taking place from the component control unit (408) to the superordinate control unit (35) via the first optical communication path (38) is disturbed by this coupled-in light (L), and
- the arc (442) is detected by the superordinate control unit (35) on account of this disturbed message transfer.

2. Method according to Claim 1,
**characterized in that**
- the arc (442) is detected by the superordinate control unit (35) only if the message transfer taking place from the component control unit (408) to the superordinate control unit (35) via the first optical communication path (38) is disturbed for a period of at least 2 seconds, in particular at least 4 seconds.

3. Method according to Claim 1 or 2,
**characterized in that**
- the power semiconductor component (202) and an input (433) of the second optical communication path (436) are arranged in an encapsulation housing (430), and the light (L) emitted by the arc (442) is guided out of the encapsulation housing (430) by means of the second optical communication path (436).

4. Method according to any of the preceding claims, **characterized in that**
- the light emitted by the arc (442) is collected and guided into the second optical communication path (436) by means of a light collecting optical unit (446).

5. Method according to Claim 4,
**characterized in that**
- the light collecting optical unit (446) is arranged at the second optical communication path (436), in particular is arranged at the input (433) of the second optical communication path (436).

6. Method according to any of the preceding claims, **characterized in that**
- the first optical communication path (38) and/or the second optical communication path (436) are/is configured in each case as an optical waveguide.

7. Method according to any of the preceding claims, **characterized in that**
- the power semiconductor component is a power semiconductor component (202) of a module (1_4) of a modular multilevel power converter (1).

8. Method according to Claim 7,
**characterized in that**
- the module (1_4) has two connections (212, 215), between which is arranged a bridging switch (405) for bridging the module in the event of a fault occurring in the module.

9. Power electronic installation (1) comprising a power semiconductor component (202), comprising a component control unit (408) assigned to the power semiconductor component (202), wherein the component control unit (408) is connected to a superordinate control unit (35) by means of a first optical communication path (38), and comprising a second optical communication path (436), which makes it possible to transfer light from the power semiconductor component (202) to the first optical communication path (38), wherein
- the second optical communication path (436) is configured such that it transfers light (L) emitted by an arc (442) burning at the power semiconductor component (202) to the first optical communication path (38) and couples it into the first optical communication path (38).

10. Power electronic installation according to Claim 9, **characterized in that**
- the power semiconductor component (202) and an input (433) of the second optical communication path (436) are arranged in an encapsulation housing (430) and the second optical communication path (436) leads out of the encapsulation housing (430).

11. Power electronic installation according to Claim 9 or 10, **characterized in that**
- a light collecting optical unit (446) configured such that it collects light emitted by the arc and guides it into the second optical communication path (436).

12. Power electronic installation according to Claim 11, **characterized in that**
- the light collecting optical unit (446) is arranged at the second optical communication path (436), in particular is arranged at the input (433) of the second optical communication path (436).

13. Power electronic installation according to any of Claims 9 to 12,
**characterized in that**
- the first optical communication path (38) and/or the second optical communication path (436) are/is configured in each case as an optical waveguide.

14. Power electronic installation according to any of Claims 9 to 13,
**characterized in that**
- the power semiconductor component is a power semiconductor component (202) of a module (1_4) of a modular multilevel power converter (1).

15. Power electronic installation according to any of Claims 9 to 14,
**characterized in that**
- the module (1_4) has two connections (212, 215), between which is arranged a bridging switch (405) for bridging the module in the event of a fault occurring in the module.

## Revendications

1. Procédé de détection d'un arc (442) électrique pour un composant (202) à semiconducteur de puissance, dans lequel une unité (408) de commande de composant associée au composant (202) à semiconducteur de puissance transmet, par un premier chemin (38) de communication optique, des messages (N) à une unité (35) de commande supérieure hiérarchiquement, dans lequel dans le procédé
- on transmet de la lumière (L) émise par l'arc (442) électrique au premier chemin (38) de communication optique au moyen d'un deuxième chemin (436) de communication optique,
- on injecte cette lumière (L) dans le premier chemin (38) de communication optique,
- par cette lumière (L) injectée, on perturbe la transmission de messages, ayant lieu de l'unité (408) de commande de composant à l'unité (35) de commande supérieure hiérarchiquement par le premier chemin (38) de communication optique, et
- on détecte l'arc (442) électrique par l'unité (35) de commande supérieure hiérarchiquement en raison de cette transmission perturbée de messages.

2. Procédé suivant la revendication 1,
**caractérisé en ce que**
- on ne détecte l'arc (442) électrique par l'unité (35) de commande supérieure hiérarchiquement que si la transmission de messages, ayant lieu de l'unité (408) de commande de composant à l'unité (35) de commande supérieure hiérarchiquement par le premier chemin (38) de communication optique, est perturbée pendant au moins 2 secondes, notamment pendant au moins 4 secondes.

3. Procédé suivant la revendication 1 ou 2,
**caractérisé en ce que**
- le composant (202) à semiconducteur de puissance et une entrée (433) du deuxième chemin (436) de communication optique sont disposés dans un boîtier (430) d'encapsulation et, au moyen du deuxième chemin (436) de communication optique, on fait sortir du boîtier (430) d'encapsulation la lumière (L) émise par l'arc (442) électrique.

4. Procédé suivant l'une des revendications précédentes, **caractérisé en ce que**
- on fait converger la lumière émise par l'arc (442) électrique et on l'introduit dans le deuxième chemin (436) de communication optique au moyen d'une optique (446) convergente.

5. Procédé suivant la revendication 4,
**caractérisé en ce que**
- l'optique (446) convergente est montée sur le deuxième chemin (436) de communication optique, en étant montée notamment à l'entrée (433) du deuxième chemin (436) de communication optique.

6. Procédé suivant l'une des revendications précédentes, **caractérisé en ce que**
- le premier chemin (38) de communication optique et/ou le deuxième chemin (436) de communication optique est conformé respectivement sous la forme d'un guide d'ondes lumineuses.

7. Procédé suivant l'une des revendications précédentes, **caractérisé en ce que**
- le composant à semiconducteur de puissance est un composant (202) à semiconducteur de puissance d'un module (1_4) d'un onduleur (1) modulaire à plusieurs niveaux.

8. Procédé suivant la revendication 7,
**caractérisé en ce que**
- le module (1_4) a deux bornes (212, 215) entre lesquelles est monté un interrupteur (405) de dérivation pour court-circuiter le module s'il apparaît un défaut dans le module.

9. Installation (1) d'électronique de puissance comprenant un composant (202) à semiconducteur de puissance, comprenant une unité (408) de commande de composant associée au composant (202) à semiconducteur de puissance, dans laquelle l'unité (408) de commande de composant est reliée à une unité (35) de commande supérieure hiérarchiquement, au moyen d'un premier chemin (38) de communication optique et comprenant un deuxième chemin (436) de communication optique, qui permet une transmission de lumière du composant (202) à semiconducteur de puissance au premier chemin (38) de communication optique, dans laquelle
- le deuxième chemin (436) de communication optique est conformé, de manière à transmettre au premier chemin (38) de communication optique de la lumière (L) émise d'un arc (442) électrique, jaillissant au composant (202) à semiconducteur de puissance et à l'injecter dans le premier chemin (38) de communication optique.

10. Installation d'électronique de puissance suivant la revendication 9,
**caractérisée en ce que**
- le composant (202) à semiconducteur de puissance et une entrée (433) du deuxième chemin (436) de communication optique sont disposés dans un boîtier (430) d'encapsulation et le deuxième chemin (436) de communication optique sort du boîtier (430) d'encapsulation.

11. Installation d'électronique de puissance suivant la revendication 9 ou 10,
**caractérisée par**
- une optique (446) convergente, qui est conformée de manière à faire converger de la lumière émise par l'arc électrique et à l'introduire dans le deuxième chemin (436) de communication optique.

12. Installation d'électronique de puissance suivant la revendication 11,
**caractérisé en ce que**
- l'optique (446) convergente est montée sur le deuxième chemin (436) de communication optique, en étant montée notamment à l'entrée (433) du deuxième chemin (436) de communication optique.

13. Installation d'électronique de puissance suivant l'une des revendications 9 à 12,
**caractérisé en ce que**
- le premier chemin (38) de communication optique et/ou le deuxième chemin (436) de communication optique est conformé respectivement sous la forme d'un guide d'ondes lumineuses.

14. Installation d'électronique de puissance suivant l'une des revendications 9 à 13,
**caractérisée en ce que**
- le composant à semiconducteur de puissance est un composant (202) à semiconducteur de puissance d'un module (1_4) d'un onduleur (1) modulaire à plusieurs niveaux.

15. Installation d'électronique de puissance suivant l'une des revendications 9 à 14,
**caractérisée en ce que**
- le module (1_4) a deux bornes (212, 215) entre lesquelles est montée un interrupteur (405) de dérivation pour court-circuiter le module s'il apparaît un défaut dans le module.
